(19) **Europäisches Patentamt / European Patent Office / Office européen des brevets**

(11) **EP 4 417 984 A1**

(12) **EUROPEAN PATENT APPLICATION**

(43) Date of publication:
**21.08.2024 Bulletin 2024/34**

(21) Application number: **23157539.0**

(22) Date of filing: **20.02.2023**

(51) International Patent Classification (IPC):
**G01R 31/26** (2020.01)    **G05B 23/02** (2006.01)

(52) Cooperative Patent Classification (CPC):
**G01R 31/2642; G05B 23/0283**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ABB SCHWEIZ AG**
**5400 Baden (CH)**

(72) Inventors:
- **Firla, Marcin**
  **31-553 Krakow (PL)**
- **Orkisz, Michal**
  **31-352 Krakow (PL)**
- **Pjetri, Erald**
  **31-036 Krakow (PL)**

(74) Representative: **AOMB Polska Sp. z.o.o.**
**ul. Rondo Ignacego Daszynskiego 1**
**00-843 Warsaw (PL)**

(54) **A METHOD FOR PREDICTING A LIFETIME OF A POWER SEMICONDUCTOR DEVICE**

(57)     The present disclosure relates to methods of predicting lifetime of a power semiconductor device. According to the invention there is provided a method for predicting a lifetime of a power semiconductor device comprising of: a) obtaining data related to working conditions of the power semiconductor device; b) calculating a switching frequency with its peaks in switching cycle on a basis of obtained data; c) calculating at least one KPI, Key Performance Indicators; d) implementing received KPIs and an at least one input feature to Machine Learning model; e) estimating lifetime of the power semiconductor device by receiving total number of switching cycles that the power semiconductor device is able to perform throughout its lifetime.

Fig. 1

EP 4 417 984 A1

## Description

## TECHNICAL FIELD

The present disclosure relates to methods of predicting lifetime of a power semiconductor device.

## BACKGROUND OF THE DISCLOSURE

The power semiconductor devices are devices used as switch or rectifier in power electronics. Power semiconductor devices are divided into power MOSFET, power diode, thyristor and IGBT (Insulatedgate bipolar transistor). Power semiconductor devices could be classified as a two-terminal device (e.g. diode) and as a three-terminal devices (e.g. power MOSFET, JFET, IGBT, BJT and thyristor).

A failure rate of the operation time comprises three parts. A first part, which is decreasing failure rate, is influenced by early failures caused by defect and weakness in design or in manufacturing process. A second part, which is constant, describes a usable lifetime of the product. A third part, which is increasing failure rate, is influenced by wear-out failures as a product is approaching its design lifetime limit. Power semiconductor devices' lifetime is usually subject to wear-out failures caused by thermosmechanical stresses during an operation.

Power semiconductor devices during their exploitation are subject to passive temperature swings, which are caused by change of ambient temperature, and active temperature swings which are caused by operation. Power loss of power semiconductor devices depends on its temperature.

Document US10705133B2 discloses a method and a device for estimating a level of damage or a lifetime expectation of a power semiconductor module comprising at least one die that is mechanically, thermally, and electrically attached to a substrate, composed of plural layers of different materials. The invention: obtains power losses of the power semiconductor module, obtains the temperature in at least two different locations of the power semiconductor module, estimates a thermal model between the at least two different locations of the power semiconductor module using the determined power losses and the obtained temperatures, determines if a notification indicating the level of damage or the lifetime expectation has to be performed according to the estimated thermal model and a reference thermal model and notifies the level and location of damage or the lifetime expectation if the determining step determines that the notification has to be performed.

Document EP3255443B1 discloses a method of monitoring the health of a semiconductor power electronic switch such as an insulated gate bipolar transistor (IGBT) is provided. The method having the steps of: measuring one or more parameters selected from the group consisting of: a rate of change of voltage dV dt across the switch; a rate of change of current di dt through the switch, a charge present on a gate of the switch ($Q_G$), a peak overshoot voltage ($V_{PO}$) across the switch, and a peak overshoot or reverse recovery current ($I_{RR}$) through the switch; and estimating the health of the switch based on the measured parameter(s).

Document EP3691098A1 discloses a method for determining whether a semiconductor module is still thermally coupled to a cooling device as intended, in which the semiconductor module is subjected to a predetermined electrical stress is applied, a temperature of a semiconductor element of the semiconductor module is detected at least for the predetermined electrical stress of the semiconductor module, the detected temperature in a first comparison with a comparison temperature is compared, the comparison temperature being assigned to the specified electrical stress during the specified cooling, and prognosis data for the remaining intended usability of the semiconductor module up to an end of usability, at least depending on the first comparison are determined.

Predicting lifetime is difficult due to many factors influencing it and manufacturing differences between chips. One of the indicators of the degree of the device wear is the total count of temperature swings that the device has experienced. The problem is to provide the estimated number and amplitude of these temperature swings as an indicator of the remaining useful lifetime. IGBTs manufacturing information provide only general plots for reading number of cycles for a given temperature. There is no straightforward method for estimating lifetime in case of operation under variable thermal amplitude stress. Typically, histograms of experienced temperature swing amplitudes are created, and they are used together with manufacturing tables to estimate an equivalent number of temperature swings which cause decrease of their lifetime.

Accordingly, it is a goal of the present disclosure to provide an effective method which is able to estimate lifetime of the power semiconductor device. The present invention allows to predict remaining lifetime of power semiconductor devices based on an actual or typical load experienced by the device and then assess the warranty period.

## SUMMARY OF THE DISCLOSURE

According to a first aspect of the present invention there is provided a method for predicting a lifetime of a power semiconductor device comprising of:

     a) obtaining data related to working conditions of the power semiconductor device;
     b) calculating a switching frequency with its peaks in switching cycle on a basis of obtained data;
     c) calculating at least one KPI, Key Performance Indicators;
     d) implementing received KPIs and an at least one input feature to Machine Learning model;

e) estimating lifetime of the power semiconductor device by receiving total number of switching cycles that the power semiconductor device is able to perform throughout its lifetime.

In one of the embodiments of the invention the obtained data is related to switching cycles from an each switching cycle and an output switching frequency from a one load cycle.

In one embodiment parameters in the obtained data related to working conditions of the power semiconductor device are divided to measured and estimated parameters.

In yet another embodiment measured parameters of working conditions of the power semiconductor device include a power, voltages, currents, an ambient temperature, and/or estimated parameters of working conditions are a chip temperature, temperature swings, degradation of the joints.

In one embodiment the at least one input feature implemented in the Machine Learning Model is selected from the list comprising:
a mean value of IGBT temperature differences caused by switching cycles within the one load cycle, a switch on time in seconds, a maximum IGBT temperature difference caused by switching cycles within the one load cycle, a number of switching cycles performed in the one load cycle, the maximum IGBT temperature in the one load cycle, a duration of the load cycle in hours, a mean value of IGBT maximum heating rates in each switching cycle within the one load cycle, a mean value of IGBT maximum cooling rates in each switching cycle within the one load cycle, a mean value of diode temperature differences caused by switching cycles within the one load cycle, a maximum diode temperature difference caused by switching cycles within the one load cycle, the maximum diode temperature in the one load cycle, a mean value of diode maximum heating rates in each switching cycle within the one load cycle, a mean value of diode maximum cooling rates in each switching cycle within the one load cycle.

Calculating the switching frequency with its peaks in the switching cycle is realized by measuring time series of a temperature throughout the load cycle and a sampling frequency of temperature measurements.

In one of the embodiments calculating the switching frequency with its peaks in switching cycle is conducted by a Fast Fourier Transformation, FFT, on a frequency of temperature measurements.

In yet another embodiment producing the Key Performance Indicators, KPI, on the basis of shape and frequency of peaks.

In one of the embodiment comprising steps, performed before step a), of learning of the Machine Learning Model:

f) preparing the Machine Learning Model on the basis of acquisition of data in a form of historical data,
g) scaling features of the acquisitioned historical data,
h) regressing the acquisitioned historical data,
i) conducting cross-validation on the acquisitioned historical data.

The steps f-i are performed in a supervised manner.

In one of the embodiments estimating lifetime of the power semiconductor device is received in the form of output features received from the Machine Learning Model as total cycles being a total number of switching cycles performed by the semiconductor device module throughout its lifetime, which is calculated with the following formula:

$$'\text{Total Cycles}' = \frac{'\text{Lifetime}_h' \times '\text{nr\_sw\_cycles}'}{'\text{load\_cycle}_h'}$$

wherein a $\text{Lifetime}_h$ is the lifetime of each module in hours, a nr_sw_cycles is a number of switching cycles and a $\text{load\_cycle}_h$ is time of one load cycle.

In one embodiment the Machine Learning Model comprises an input layer, an output layer, and two hidden layers, where the input layer has thirteen neurons, the two hidden layers have eleven neurons each and the output layer has a single neuron.

The power semiconductor device is IGBT, diode, thyristors or IGCT.

According to a second aspect of the present invention there is provided the system of predicting a lifetime of the power semiconductor device performing the method comprising:

a test stand configured for obtaining data related to working conditions of the power semiconductor device using,
a computation unit configured to run the Machine Learning Model and to estimate lifetime of the power semiconductor device by receiving total number of switching cycles that the power semiconductor device is able to perform throughout its lifetime.

In one embodiment comprising a KPI unit configured to calculating at least one KPI, Key Performance Indicators, on a basis of obtained measurements.

In one of the preferred embodiments the Machine Learning model is configured to receive measurements produced into Key Performance Indicators, KPI.

Another aspect of the invention is a computer program product comprising instructions which, when the program is executed by a computer, cause the computer to carry put the method.

Another aspect of the invention is a computer readable medium comprising instructions which, when executed by a computer, cause the computer to carry out the method.

## BRIEF DESCRIPTION OF THE DRAWINGS

The present disclosure will be now discussed with reference to the drawings, which show in:

Fig.1 -    depicts a lifetime prediction process,

Fig. 2 -    depicts a cycle extraction after estimating output frequency and identifying peaks,

Fig. 3 -    depicts a Machine Learning Model performance,

Fig.4 -    depicts a diagram of method for switching cycle extraction,

Fig. 5 -    depicts a lead cycle,

Fig. 6 -    depicts estimated switching frequency,

Fig. 7 -    depicts found peaks in load cycle timeseries,

Fig. 8 -    depicts extracted cycles.

## DETAILED DESCRIPTION OF THE DISCLOSURE

For a proper understanding of the disclosure, in the detailed description below, corresponding elements or parts of the disclosure will be denoted with identical reference numerals in the drawings.

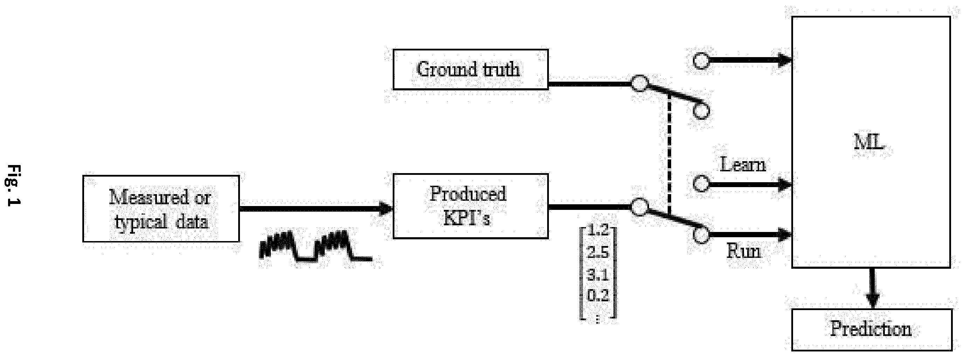

Present invention relies on predicting a remaining useful lifetime of a power semiconductor device, based on an actual or typical load, electrical and thermal, experienced by the device. Fig. 1 presents an idea of the method. Continuous power cycling introduces a certain amount of losses which dissipates in the form of heat. Therefore, power cycling causes thermal cycling which is a process of the device moving from hot to cold states that causes failures in electronics. Temperature is a variable which has a substantial impact on the lifetime of an Insulated Gate Bipolar Transistor (IGBT) module.

In this embodiment of the invention the power semiconductor is the transistor IGBT's. The person skilled in the art would know that the other devices may be thyristors, IGCT's (Integrated gatecommutated thyristors) or a diode. Typically, semiconductor various types of devices. Those are considered when the functional point of view is significant. On the other hand, when the material point of view is considered, the device is wide bandgap semiconductors or conventional semiconductors like silicon which have a bandgap in the range of 0.6 - 1.5 eV. Wide bandgap materials for example SiC, have bandgaps in the range above 2 eV and they allow devices to operate at much higher voltages and temperatures than conventional semiconductors like silicon or gallium arsenide.

Power cycling raises and lowers a chip-junction temperature at relatively short intervals in a timeframe of seconds. Operation of a power semiconductor in an electric drive is characterized by power cycling. The power-cycling capability of power semiconductor devices depend on an absolute junction temperature, the temperature swing, the duration and the on-time of the cycle. During the power cycling test, the same conditions such as load current and absolute junction temperature are periodically repeated.

Power cycling occurs when a semiconductor chip inside a package is loaded by current and is heated by the losses caused by the current flow. During heating, a temperature gradient arises inside the package and after switching off the current the chip cools down and the temperature gradient disappears. That leads to wearing out the semiconductor packages.

There can be identified two types of cycles. First cycle type is a result of thermal cycling due to load cycle and it is referred to as load cycle. Second type is the most frequent cycling. This is caused by the output switching frequency, hence are named switching cycles.

Present inventions disclose a method for predicting the lifetime of the power semiconductor device. This method comprises following steps:

a) obtaining data related to working conditions of the power semiconductor device;
b) calculating switching frequency with its peaks in switching cycle;
c) calculating at least one KPI, Key Performance Indicators;
d) implementing received KPIs and input featured to Machine Learning model;
e) estimating lifetime of the power semiconductor device by receiving total number of switching cycles that the power semiconductor device is able to perform throughout its lifetime.

In this embodiment of the invention, the obtained data is related to switching cycles from each switching cycle and an output switching frequency from a one load cycle. In order to define power cycling profile there must be identified switching cycles in one load cycle. Depending on the load profile, these cycles can have the same shape throughout the load cycle or a unique one.

The obtained data related to working conditions of the power semiconductor device in this embodiment of the invention are parameters which are divided to measured and estimated parameters. The measured parameters are a power, voltages, currents and an ambient temperature. The estimated parameters are a chip temperature, temperature swings and a degradation of the joints.

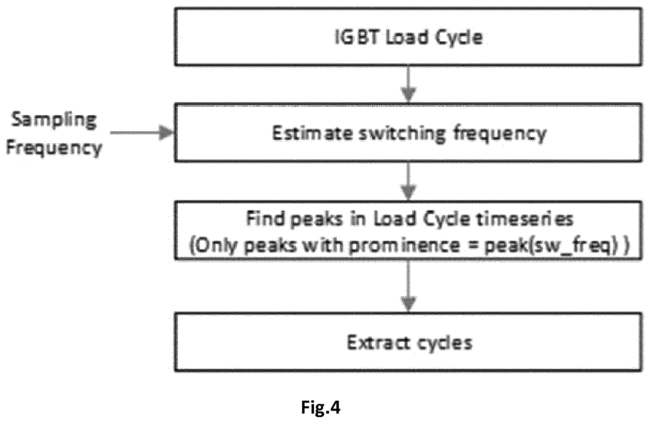

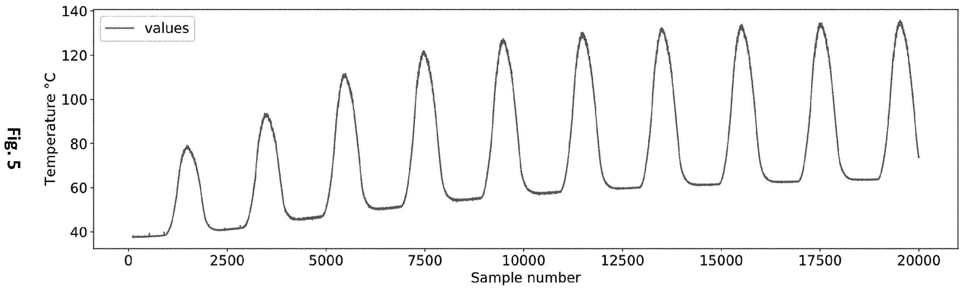

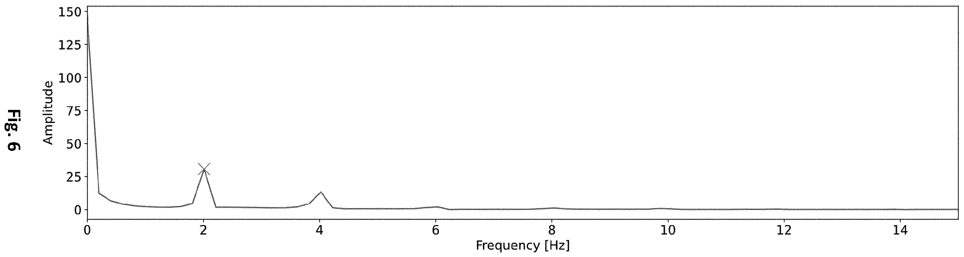

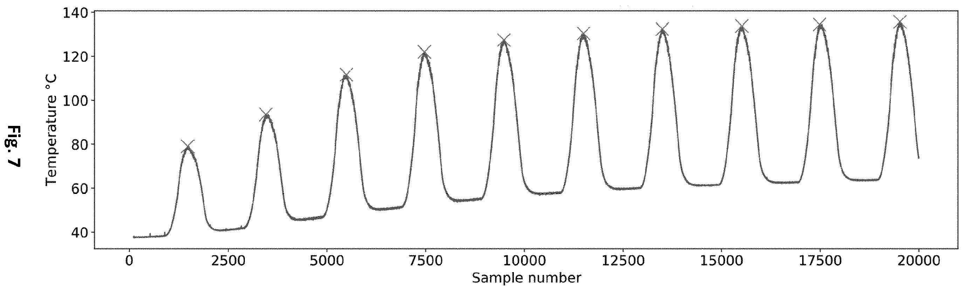

A diagram which shows a method for switching cycle extraction is shown in Fig. 4. Each individual switching cycle is extracted from the load cycle which is shown in Fig. 5. Extracting switching cycling needs time series measurements of temperature throughout the load cycle and sampling frequency as an input. A Fast Fourier Transformation, FFT, is applied to the obtained input in order to estimate switching frequency and its respective peak what can be seen in Fig. 6. The received dominant peak in a spectrum corresponds to the one related to switching frequency and it is used as an input to a peak detection algorithm, Fig. 7. The peak detection algorithm detects all peaks in the timeseries. Prominence of detected peaks should be equal to the magnitude of the dominant peak in the FFT. In this way, only peaks due to output frequency are identified.

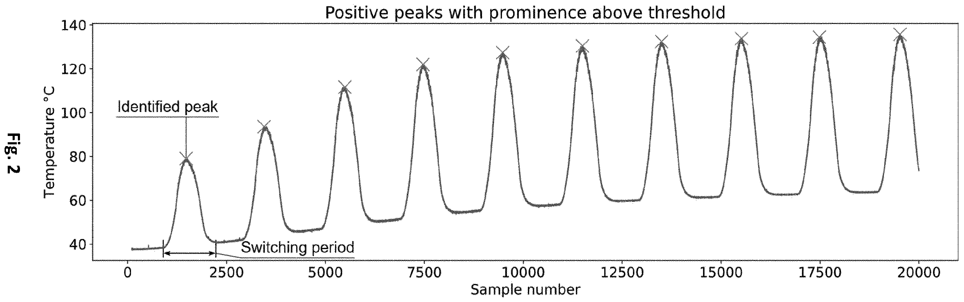

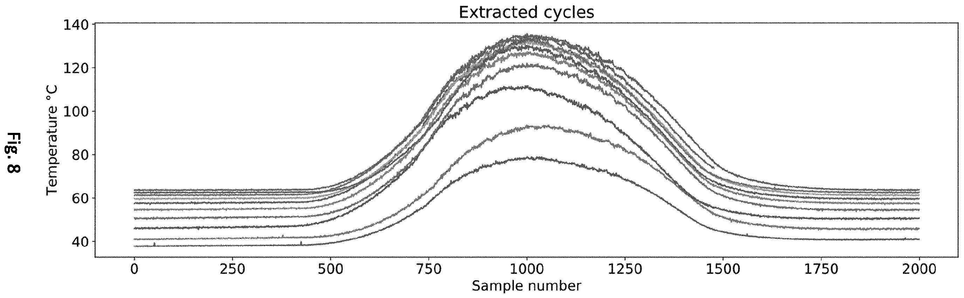

Fig. 2 shows identified peaks and switching periods. Each switching cycle has its own peak. After estimating switching frequency and peaks, the switching cycles are extracted from the timeseries by taking out the values which are within one switching period, how it is shown in Fig. 8.

Each cycle extracted with the method presented in that point is described mathematically and that result is used as input features. During the load cycle, the following input features are obtained and at the same time each of this feature is a Key Performance Indicator. In this embodiment the following features are:

1. 'mean_d_T_igbt' - Mean value of IGBT temperature differences caused by switching cycles within one load cycle.

2. 't_on_igbt' - Switch on time in seconds

3. 'max_d_T_igbt' - Maximum IGBT temperature difference caused by switching cycles within one load cycle

4. 'nr_sw_cycles_igbt' - Number of switching cycles performed in one load cycle

5. 'max_T_igbt' - Maximum IGBT temperature in one load cycle

6. 'load_cycle_h_igbt' - Duration of a load cycle in hours

7. 'mean_max_deriv_T_igbt' - Mean value of IGBT maximum heating rates in each switching cycle within one load cycle

8. 'mean_min_deriv_T_igbt'- Mean value of IGBT maximum cooling rates in each switching cycle within one load cycle

9. 'mean_d_T_diode' - Mean value of DIODE temperature differences caused by switching cycles within one load cycle.

10. 'max_d_T_diode' - Maximum DIODE temperature difference caused by switching cycles within one load cycle

11. 'max_T_diode' - Maximum DIODE temperature in one load cycle

12. 'mean_max_deriv_T_diode' - Mean value of DIODE maximum heating rates in each switching cycle within one load cycle

13. 'mean_min_deriv_T_diode' - Mean value of DIODE maximum cooling rates in each switching cycle within one load cycle

The input features are implemented into a Machine Learning Model. In this embodiment of the invention the Machine Learning Model's learning is conducted before above-mentioned step a) and comprises following steps:

f) preparing the Machine Learning Model on the basis of acquisition of data in a form of historical data,
g) scaling features of the acquisitioned historical data,
h) regressing the acquisitioned historical data,
i) conducting cross-validation on the acquisitioned historical data.

Machine learning divides into three models: supervised, unsupervised and semi-supervised. The division relies on difference how each algorithm learns. The supervised one uses labeled dataset to train algorithms. After implying data, the model adjusts respectively. Methods used in supervised learning may include neural networks, naive bayes, linear regression, logistic regression, random forest, and support vector machine (SVM).

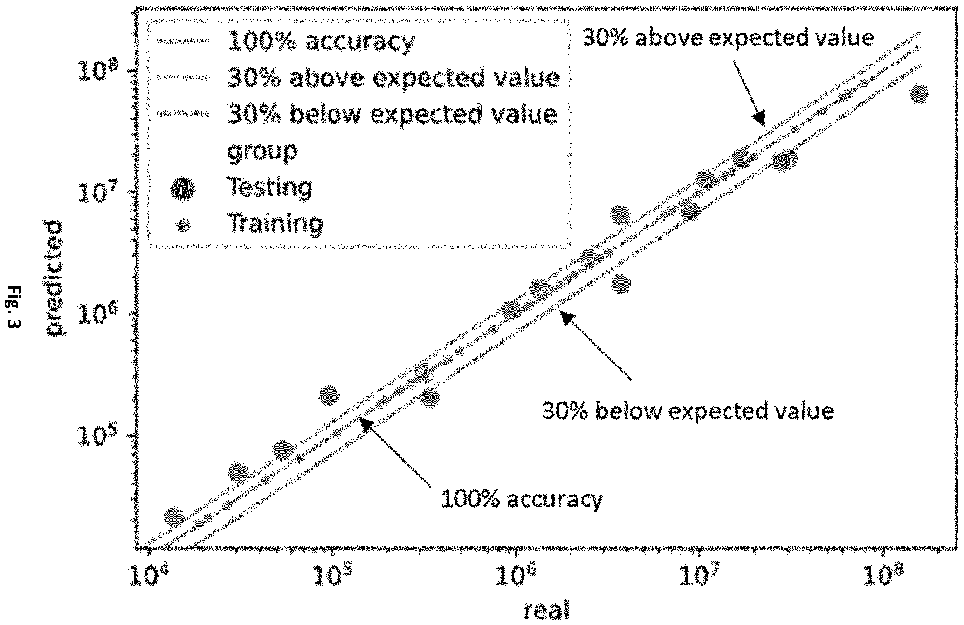

In this embodiment of the invention, the Machine Learning Model performs in supervised manner. A proposed model for the historical data which were inspected is learning with 75% usage of the data and the remaining 25% is used for the model performance evaluation. The Machine Learning Model is able to estimate total number of cycles that is within a margin of about 30% in most of the cases. The scaling features in this embodiment are presented by the MaxAbs Scaler. The process of regression includes Ada Boost Regressor, Gradient Boosting Regressor, and Random Forest Regressor. Ensemble methods are characterized by the use of combination of a few regressors at once. The cross-validation process enables possibility to better optimize the result on available historical data. As a result, the data shown in Fig. 3 is achieved. Fig. 3 shows the Machine Learning Model performance by comparing total cycles available from the data, 'real' axis, versus estimated values on 'predicted' axis.

One of the embodiments of the inventions discloses a neural network described as sequential model with two hidden layers. An input layer has number of neurons equal to the number of available features. In this embodiment number of neurons is 13. An output layer has one single neuron and two hidden layers have 11 neurons each. The activation function is exponential and MSE metric for loss is utilized. It should be noted that other machine learning solution are also possible, and the abovementioned example should be treated as an example.

Estimating lifetime of the power semiconductor device is received in the form of output features received from the Machine Learning Model as total cycles being a total number of switching cycles performed by the semiconductor device module throughout its lifetime, which is calculated with the following formula:

$$'\text{Total Cycles}' = \frac{'\text{Lifetime}'_h \times '\text{nr\_sw\_cycles}'}{'\text{load\_cycle}'_h}$$

A Lifetime$_h$ is the lifetime of each module in hours, a nr_sw_cycles is a number of switching cycles and a load_cycle$_h$ is time of one load cycle. The proposed output features are designed in the way that estimation of one value is sufficient to compute the other value.

The present invention discloses a system of predicting a lifetime of the power semiconductor device performing the method according to the method of predicting a lifetime of a power semiconductor device. The system comprises in this embodiment of the invention a test stand and a computation unit. The test stand is configured to obtain data related to working conditions of the power semiconductor device using. The computation unit is configured to run the Machine Learning Model and to estimate lifetime of the power semiconductor device by receiving total number of switching cycles that the power semiconductor device is able to perform throughout its lifetime.

In this embodiment of the invention the system comprises a KPI unit configured to calculating at least one KPI, Key Performance Indicators, on a basis of obtained measurements. In this embodiment the Machine Learning model is configured to receive measurements produced into Key Performance Indicators, KPI.

The invention discloses a computer program product which comprises instructions causing a computer to carry out the above-mentioned method. The computer program product works when is executed by the computer. The invention discloses a computer readable medium which comprises instruction allowing the computer to carry out the above-mentioned method of predicting a lifetime of a power semiconductor device.

**Claims**

1. A method for predicting a lifetime of a power semiconductor device comprising of:

   a) obtaining data related to working conditions of the power semiconductor device;
   b) calculating a switching frequency with its peaks in switching cycle on a basis of obtained data;
   c) calculating at least one KPI, Key Performance Indicators;
   d) implementing received KPIs and an at least one input feature to Machine Learning model;
   e) estimating lifetime of the power semiconductor device by receiving total number of switching cycles that the power semiconductor device is able to perform throughout its lifetime.

2. The method according to claim 1, **wherein** the obtained data is related to switching cycles from an each switching cycle and an output switching frequency from a one load cycle.

3. The method according to any claim 1-2, **wherein** parameters in the obtained data related to working conditions of the power semiconductor device are divided to measured and estimated parameters.

4. The method according to claim 3, **wherein** measured parameters of working conditions of the power semiconductor device include a power, voltages, currents, an ambient temperature, and/or estimated parameters of working conditions are a chip temperature, temperature swings, degradation of the joints.

5. The method according to claim 4, **wherein** the at least one input feature implemented in the Machine Learning Model is selected from the list comprising: a mean value of IGBT temperature differences caused by switching cycles within the one load cycle, a switch on time in seconds, a maximum IGBT temperature difference caused by switching cycles within the one load cycle, a number of switching cycles performed in the one load cycle, the maximum IGBT temperature in the one load cycle, a duration of the load cycle in hours, a mean value of IGBT maximum heating rates in each switching cycle within the one load cycle, a mean value of IGBT maximum cooling rates in each switching cycle within the one load cycle, a mean value of diode temperature differences caused by switching cycles within the one load cycle, a maximum diode temperature difference caused by switching cycles within the one load cycle, the maximum diode temperature in the one load cycle, a mean value of diode maximum heating rates in each switching cycle within the one load cycle, a mean value of diode maximum cooling rates in each switching cycle within the one load cycle.

6. The method according to any claim 1-5, **wherein** calculating the switching frequency with its peaks in the switching cycle is realized by measuring time series of a temperature throughout the load cycle and a sampling frequency of temperature measurements.

7. The method according to any claim 1-6, **wherein** calculating the switching frequency with its peaks in switching cycle is conducted by a Fast Fourier Transformation, FFT, on a frequency of temperature measurements.

8. The method according to any claim 1-7, **wherein** producing the Key Performance Indicators, KPI, on the basis of shape and frequency of peaks.

9. The method according to any claim 1-8, **wherein** comprising steps, performed before step a), of learning of the Machine Learning Model:

  f) preparing the Machine Learning Model on the basis of acquisition of data in a form of historical data,
  g) scaling features of the acquisitioned historical data,
  h) regressing the acquisitioned historical data,
  i) conducting cross-validation on the acquisitioned historical data.

10. The method according to claim 9, **wherein** the steps f-i are performed in a supervised manner.

11. The method according to any claim 1-10, **wherein** estimating lifetime of the power semiconductor device is received in the form of output features received from the Machine Learning Model as total cycles being a total number of switching cycles performed by the semiconductor device module throughout its lifetime, which is calculated with the following formula:

$$'\text{Total Cycles}' = \frac{'\text{Lifetime}'_h \times '\text{nr\_sw\_cycles}'}{'\text{load\_cycle}'_h}$$

wherein a Lifetime$_h$ is the lifetime of each module in hours, a nr_sw_cycles is a number of switching cycles and a load_cycle$_h$ is time of one load cycle.

12. The system of predicting a lifetime of the power semiconductor device performing the method according to anyone of claims 1-11 comprising:

  a test stand configured for obtaining data related to working conditions of the power semiconductor device using,
  a computation unit configured to run the Machine Learning Model and to estimate lifetime of the power semiconductor device by receiving total number of switching cycles that the power semiconductor device is able to perform throughout its lifetime.

13. The system according to claim 12, **wherein** comprising a KPI unit configured to calculating at least one KPI, Key Performance Indicators, on a basis of obtained measurements.

14. A computer program product comprising instructions which, when the program is executed by a computer, cause the computer to carry put the method of anyone of claims 1-13.

15. A computer readable medium comprising instructions which, when executed by a computer, cause the computer to carry out the method of anyone of claims 1-13.

ML

Prediction

Learn

Run

Ground truth

Produced KPI's

$\begin{bmatrix} 1.2 \\ 2.5 \\ 3.1 \\ 0.2 \\ \vdots \end{bmatrix}$

Measured or typical data

**Fig. 1**

**Fig. 2**

Fig. 3

IGBT Load Cycle

Sampling Frequency → Estimate switching frequency

Find peaks in Load Cycle timeseries
(Only peaks with prominence = peak(sw_freq) )

Extract cycles

**Fig.4**

Fig. 5

**Fig. 6**

**Fig. 7**

Fig. 8

**EP 4 417 984 A1**

Europäisches Patentamt
European Patent Office
Office européen des brevets

# EUROPEAN SEARCH REPORT

Application Number

EP 23 15 7539

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RAHIMPOUR SAEED ET AL: "An Overview of Lifetime Management of Power Electronic Converters", IEEE ACCESS, IEEE, vol. 10, 12 October 2022 (2022-10-12), pages 109688-109711, XP011924133, DOI: 10.1109/ACCESS.2022.3214320 [retrieved on 2022-10-13] * the whole document * | 1-15 | INV. G01R31/26 G05B23/02 |
| A | CN 109 101 738 A (UNIV HEBEI TECHNOLOGY) 28 December 2018 (2018-12-28) * the whole document * | 1-15 | |
| A | EP 3 819 735 A1 (ABB SCHWEIZ AG [CH]) 12 May 2021 (2021-05-12) * the whole document * | 1-15 | |

| | | | TECHNICAL FIELDS SEARCHED (IPC) |
|---|---|---|---|
| | | | G01R G05B |

The present search report has been drawn up for all claims

| Place of search | Date of completion of the search | Examiner |
|---|---|---|
| Munich | 9 August 2023 | Kleiber, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

16

**ANNEX TO THE EUROPEAN SEARCH REPORT
ON EUROPEAN PATENT APPLICATION NO.**

EP 23 15 7539

This annex lists the patent family members relating to the patent documents cited in the above-mentioned European search report.
The members are as contained in the European Patent Office EDP file on
The European Patent Office is in no way liable for these particulars which are merely given for the purpose of information.

09-08-2023

| Patent document cited in search report | | Publication date | Patent family member(s) | | | Publication date |
|---|---|---|---|---|---|---|
| CN 109101738 | A | 28-12-2018 | NONE | | | |
| EP 3819735 | A1 | 12-05-2021 | CN | 114641741 | A | 17-06-2022 |
| | | | EP | 3819735 | A1 | 12-05-2021 |
| | | | EP | 4055455 | A1 | 14-09-2022 |
| | | | US | 2022382269 | A1 | 01-12-2022 |
| | | | WO | 2021089298 | A1 | 14-05-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10705133 B2
- EP 3255443 B1
- EP 3691098 A1